**Europäisches Patentamt**

**European Patent Office**

**Office européen des brevets**

(19)

(11) Veröffentlichungsnummer: **0 190 455**

**B1**

(12) # EUROPÄISCHE PATENTSCHRIFT

(45) Veröffentlichungstag der Patentschrift:
13.09.89

(51) Int. Cl.⁴: **G 01 R 15/06**

(21) Anmeldenummer: **85116368.3**

(22) Anmeldetag: **20.12.85**

(54) **Verfahren, Schaltung und Einrichtung zur Beseitigung der Gleichspannungskomponente eines kapazitiven Wechselspannungsteilers.**

(30) Priorität: **26.01.85 DE 3502638**

(43) Veröffentlichungstag der Anmeldung:
**13.08.86 Patentblatt 86/33**

(45) Bekanntmachung des Hinweises auf die Patenterteilung:
**13.09.89 Patentblatt 89/37**

(84) Benannte Vertragsstaaten:
**AT BE CH DE FR LI SE**

(56) Entgegenhaltungen:
**DE-A-2 659 051**
**DE-A-2 846 285**

(73) Patentinhaber: **MWB MESSWANDLER- BAU AG,
Nürnberger Strasse 199, D-8600 Bamberg (DE)**

(72) Erfinder: **Schmitt, Robert, Dipl.- Ing. (FH),
Bamberger Straße 8, D-8601 Gundelsheim (DE)**
Erfinder: **Steffens, Peter, Dipl.- Ing.,
Steigerwaldstrasse 21, D-8602 Stegaurach (DE)**

(74) Vertreter: **Hufnagel, Walter, Dipl.- Ing., Dipl.-
Wirtsch.- Ing., Dorner & Hufnagel Patentanwälte
Bad Brückenauer Str. 19, D-8500 Nürnberg 90 (DE)**

LIBER, STOCKHOLM 1989

EP 0 190 455 B1

## Beschreibung

Die vorliegende Erfindung bezieht sich auf ein Verfahren zur Beseitigung der Gleichspannungskomponente eines kapazitiven Wechselspannungsteilers, insbesondere für mittlere und hohe Spannungen gemäß dem Oberbegriff des Anspruches 1, sowie auf eine Schaltung zur Ausübung dieses Verfahrens und auf eine Einrichtung mit einer solchen Schaltung.

Ein derartiges Verfahren bzw. eine solche Anordnung sind bereits aus der DE-A-2 634 595 bekannt. Dort ist parallel zum an Masse liegenden Kondensator eines kapazitiven Spannungsteilers als Schaltvorrichtung die Reihenschaltung eines Schalters mit einem sehr niederohmigen Widerstand und außerdem eine Steuervorrichtung dazu parallel angeschlossen. Die Steuervorrichtung öffnet nach dem Wiedereinschalten der Wechselspannung den Schalter in Abhängigkeit vom ersten Nulldurchgang nach einer Verzögerungszeit von etwa 1 Millisekunde. Unter normalen Arbeitsbedingungen wird hierdurch der normale Betriebszustand nicht später als nach einer halben Schwingungsperiode nach der Wiedereinschaltung der Leitung erreicht und der Eingang ist während dieser Zeit kurzgeschlossen.

Die Messung hoher Spannungen geschieht derzeit zumeist mit induktiven Spannungswandlern. Je höher die Spannungsebene wird, desto teurer werden diese Einrichtungen.

In der Vergangenheit wurden daher immer wieder Versuche unternommen, die Hochspannungsmessung mittels kapazitiver Hochspannungsteiler und nachfolgender Meßverstärker durchzuführen.

Ein Problem stellt dabei das Auftreten von Gleichspannungsgliedern in dem kapazitiven Teiler dar. Diese Gleichspannungen treten dann auf, wenn der unter Hochspannung stehende Teiler in einem Augenblick abgeschaltet wird, in welchem die Spannung nicht Null ist. Dann bleibt am Verstärkereingang eine Gleichspannung anstehen. Selbst wenn diese über den Eingangswiderstand des Verstärkers abgebaut ist, tritt beim Wiederzuschalten der Hochspannung die im Oberspannungskondensator gespeicherte Ladung als Gleichspannungskomponente auf, die der Wechselspannung unterlagert ist. Das verschiebt die für Schutzeinrichtungen wichtigen Nulldurchgänge der Ausgangsspannung und führt bei potentialfreien Wandlerausgängen zu deren Sättigung.

In Verbesserung der eingangs erwähnten Anordnung ist in der DE-A-2 846 285 eine Schaltung vorgeschlagen, bei der die Entladeimpedanz bei Feststellung von Gleichspannungskomponenten zu- und nach einigen Perioden wieder abgeschaltet wird, was die oben beschriebenen Nachteile nur während einer kürzeren Zeit hervorruft.

In dieser Literaturstelle ist ein zweiter Hochspannungsteiler vorgesehen, der einen zweiten, Gleichspannung sperrenden Verstärkereingang speist und es wurden Teiler vorgeschlagen, die mehrere Meß- oder Steuerkondensatoren enthalten, um verschiedene Eingangsspannungen verschieden zu verarbeiten und logische Entscheidungen zu treffen, die ein Glied veränderlicher Impedanz am Meßeingang im Sinne der Gleichspannung mehrere Halbperioden lang abwechselnd ein- und ausschaltet bis die Gleichspannungskomponente abgeklungen ist.

Das Glied veränderlicher Impedanz ist im einfachsten Fall ein Widerstand und ein in Reihe dazu angeordneter Schalter. Es kann auch ein in seinem Widerstand steuerbarer Halbleiter oder ein Register von Schaltern mit gleichen oder verschiedenen Widerständen sein, wie sie von Digital-Analogwandlern bekannt sind.

Weiterhin wurden Verstärker mit rein elektronischen Filtern gebaut, die die Gleichspannungskomponente aus dem Meßsignal ausfiltern. Aber dabei ist es sehr schwierig, die heutigen Anforderungen an Genauigkeit nach Amplitude und Phase, an den Frequenzgang und das Einschwingverhalten zu einem tragbaren Kompromiß zu führen. Ferner ist eine solche Anordnung schwierig auf ihre Betriebssicherheit zu überwachen - wie das üblicherweise mit dem sogenannten Längsvergleich erfolgt -, da für eine Übergangszeit die Ausgangsspannung nicht gleich der Eingangsspannung ist.

Heutige schnelle Schutzeinrichtungen verlangen schon nach Millisekunden nach Verstärkerausgangsspannungen, die ein gutes Abbild der Hochspannung sind und keine zu Fehlschaltungen führenden Verlagerungen oder Verschiebungen enthalten.

Diese Aufgabenstellung führte zu den vorbekannten Lösungen gemäß der DE-A-2 846 285 und der DE-A-2 634 595. Der Grundgedanke der DE-A-2 634 595 ist - im Gegensatz zum Gegenstand gemäß der DE-A-2 846 285 - daß der Gleichspannungsanteil nicht allmählich in mehreren Schritten, sondern kurzzeitig und schlagartig zum frühestmöglichen Zeitpunkt aus dem einfachen Hochspannungsteiler total entfernt wird.

Durch diese bekannten Kurzschlußschaltungen tritt immer eine Verfälschung der zu messenden Meßwechselspannung im Mittel- und Hochspannungsbereich auf.

Mit der vorliegenden Erfindung soll demgegenüber die Aufgabe gelöst werden, den Gleichspannungsanteil der Meßwechselspannung möglichst ohne Verfälschung des Abbildes der zu messenden Mittel- oder Hochspannung schnellstmöglich zu entfernen. Dabei sollen große, aufwendige Bauteile, wie beispielsweise induktive Spannungswandler, Kurzschlußschalter oder dgl., vermieden werden.

Gelöst wird diese Aufgabe durch die im Kennzeichen des Anspruches 1 sowie der Ansprüche 2, 7 und 11 angegebenen Merkmale.

Durch die Digitalisierung der Meßwechselspannung in einem Parallelzweig des Verstärkers und gemäß dem Kennzeichen des Anspruches 1 durch die Integration der über eine Periode der Meßwechselspannung erhaltenen Gleichspannungskomponente und deren invertierte Eingabe in den Meßverstärker wird eine Beeinflussung der Meßwechselspannung vollkommen vermieden und außerdem in sehr kurzer Zeit der Gleichspannungsanteil vollkommen kompensiert. Durch die Integration über eine Periode werden außerdem höherfrequente Störspannungen eliminiert, so daß tatsächlich nur der reine Gleichspannungsanteil erhalten und damit eine genaue Kompensation ermöglicht wird.

Das gleiche Endergebnis wird erreicht, wenn man gemäß dem Kennzeichen des Anspruches 2 die Meßwechselspannung in einem Parallelzweig digitalisiert und aus mehreren Zeitabschnitten einer Halbperiode den Mittelwert bildet und diesen mit dem eine Halbperiode früher gebildeten Mittelwert vergleicht und die erhaltene Spannungsdifferenz invertiert dem Meßverstärker eingibt. Hierdurch erhält man eine Kompensation schon zu einem früheren Zeitpunkt.

Weitere vorteilhafte Einzelheiten der Erfindung sind in den Unteransprüchen angegegeben und werden nachfolgend an Hand eines in der Zeichnung veranschaulichten Ausführungsbeispieles näher beschrieben. Dabei zeigen:

Fig. 1    eine Prinzipschaltung zur Ausführung der Erfindung,

Fig. 2    eine digitalisierte Meßspannungskurve,

Fig. 3    die Wirkungsweise beim Einschalten im Nulldurchgang bei Abwesenheit eines Gleichspannungsanteiles,

Fig. 4    die Wirkungsweise beim Einschalten im Scheitelpunkt bei Abwesenheit eines Gleichspannungsanteiles,

Fig. 5    die Wirkungsweise beim Einschalten im Nulldurchgang bei Anwesenheit eines Gleichspannungsanteiles,

Fig. 6    die Wirkungsweise bei einem Halbperioden-Zeitabschnittvergleich.

An einem Wechselspannungsnetz 1 ist ein aus dem Oberspannungskondensator 2 und dem Unterspannungskondensator 3 gebildeter kapazitiver Spannungsteiler 4 angeschlossen. Am Verbindungspunkt 5 des kapazitiven Spannungsteilers 4 ist ein Trennkondensator 6 mit seiner einen Elektrode 7 angeschlossen. Vorzugsweise ist zwischen dem Trennkondensator 6 und dem Verbindungspunkt 5 ein Spannungsteiler 8 aus insbesondere ohmschen Impedanzen 9, 10 eingeschaltet. Dieser dient dazu, die Meßwechselspannung $U_M$ auf Werte zu ermäßigen, die für die nachfolgenden Bauelemente, wie integrierte Halbleiterschaltungen (IC's), unschädlich sind, also beispielsweise auf 5 V. Gegebenenfalls kann noch ein Verstärker 11, insbesondere zur Hervorhebung der Meßwechselspannung $U_M$ gegenüber Störspannungen, vorgesehen sein.

Die andere Elektrode 12 des Trennkondensators 6 ist mittels einer Leitung L1, beispielsweise über einen Widerstand 13 unmittelbar mit einem Meßverstärker 14 verbunden, an dessen Ausgang die Primärwicklung 15 eines Meßwandlers 16 angeschlossen ist. Parallel zum Widerstand 13 liegt gemäß einem ersten Ausführungsbeispiel der Erfindung in der Leitung L2 die Reihenschaltung eines Analog-Digitalwandlers 17 mit einem digitalen Integrator 18 und mit einem Digital-Analogwandler 19, sowie gegebenenfalls einem Widerstand 20. Ein Mikroprozessor 21 dient zur Ansteuerung der Baugruppen 17, 18, 19 über einen internen Taktgenerator 22 und zur zeitlichen Steuerung des digitalen Integrators 18 sowie gegebenenfalls auch zur Verzögerung der gemessenen Werte relativ zur Meßwechselspannung $U_M$. Günstigerweise wird dabei ein Mikroprozessor verwendet, der bereits die Bausteine, beispielsweise RAMs und/oder ROMs, enthält, mit denen ein Analog-Digitalwandler, ein digitaler Integrator und ein Digital-Analogwandler realisierbar sind. Die Realisierung erfolgt dann durch entsprechende Programmierung des Mikroprozessors. Die Ansteuerung erfolgt durch den integrierten Zeitgenerator.

Die Wirkungsweise dieser Schaltung und der Verfahrensablauf der Gleichspannungskompensation des in der Meßwechselspannung $U_M$ enthaltenen Gleichspannungsanteils $U_G$ durch Integration ist wie folgt:

Die am Trennkondensator 6 an dessen Elektrode 12 anstehende Meßwechselspannung $U_M$ wird unmittelbar über den Widerstand 13 dem Meßverstärker 14 eingegeben. Gleichzeitig gelangt die Meßwechselspannung $U_M$ an den Analog-Digitalwandler 17. Dieser wird durch den Taktgenerator 22 in einer solchen Taktfrequenz angesteuert, daß er die Periodendauer T der Netzfrequenz des Wechselspannungsnetzes 1 in eine Vielzahl von Zeitabschnitten t unterteilt und je Zeitabschnitt t den zugehörigen Spannungswert, insbesondere in digitaler Form, beispielsweise einem 4-, 8- oder 16-Bit - Muster ausgibt. Dieser Wert wird dem Integrator 18 eingegeben.

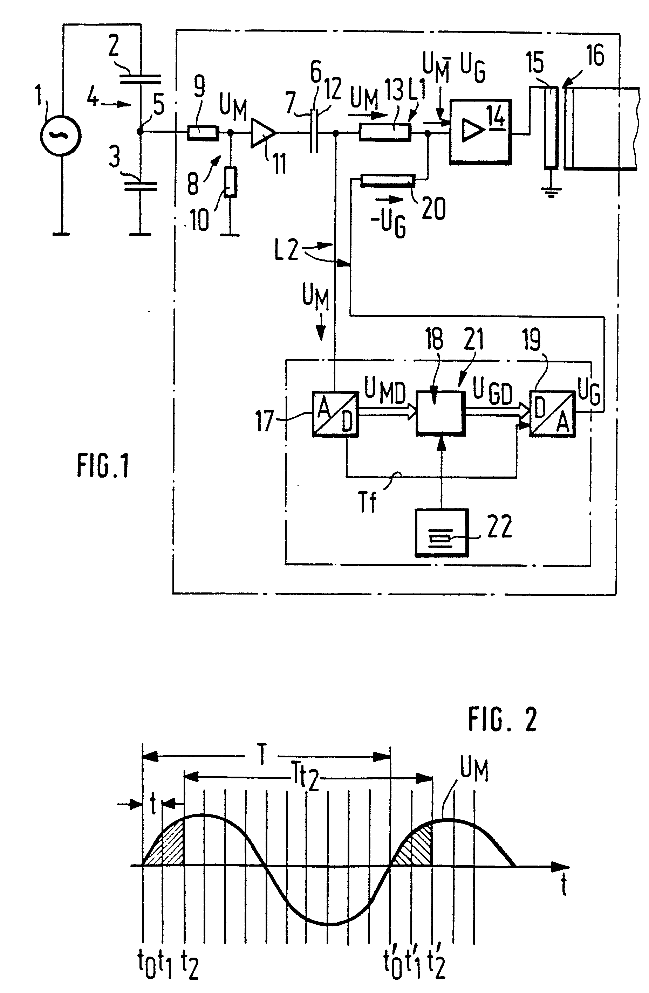

Letzterer wird mit der gleichen Taktfrequenz Tf und gleichzeitig so enge steuert, daß er immer je Takt über eine Periodendauer T integriert und den jeweiligen integrierten Wert ausgibt. Diese Funktionsweise ist in Fig. 2 näher dargestellt. Wie ersichtlich, ist die Periodendauer T in Zeitabschnitte t unterteilt. Der Integrator 18 bildet jeweils das Integral über die Periodendauer T, also beispielsweise vom Zeitpunkt $t_0$ bis $t_0'$. Ohne Gleichspannungsanteil ist also der integrierte Wert zum Zeitpunkt $t_0'$ gleich Null. Ebenso ist er beispielsweise zum Zeitpunkt $t_2' = 0$, da über die Periodendauer $T_{t2}$ der Integralwert von $t_0$ bis $t_2$ wegfällt (feingestrichelte Fläche), dafür aber derjenige von $t_0$ bis $t_2'$ hinzukommt (grobgestrichelte Fläche). Auf diese Weise kann jeder in einem Zeitabschnitt t auftretende Gleichspannungsanteil sofort festgestellt werden. Der damit in digitaler Form eventuell vorhandene Gleichspannungswert $U_{GD}$ wird dem D/A-Wandler 19 zugeführt, der aus seinem Ausgang die analoge Gleichspannung $U_G$ ausgibt. Diese wird entweder gleich im D/A-Wandler 19 oder in einem nachgeschalteten Inverter invertiert und damit in Gegenphase zu dem eventuell vorhandenen Gleichspannungsanteil in der Meßwechselspannung $U_M$ dem Meßverstärker 14 eingegeben, der damit den reinen Wechselspannungswert erhält.

Gegebenenfalls wird die Meßwechselspannung $U_M$ oder der Gleichspannungsanteil $U_G$ bzw. -$U_G$ durch eine Verzögerungseinrichtung, beispielsweise durch entsprechende Programmierung des Mikroprozessors 21, so verzögert, daß am Eingang des Meßverstärkers 14 der Gleichspannungsanteil eines Abschnittes t dem gleichen Zeitabschnitt der Meßwechselspannung $U_M$ am Eingang des Meßverstärkers 14 entspricht, also beide in Phase sind. Gegebenenfalls kann die Verzögerung so ausgelegt sein, daß die beiden bis zu einige Perioden T gegeneinander versetzt sind, aber die Zeitabschnitte t einander entsprechen.

Bei einem Ausführungsbeispiel mit einer Netzfrequenz von 50 Hz besitzt eine Periode die Zeitdauer 20 ms, d.h. T = 20 ms. Diese bildet das Integrationsintervall. Für die Eingangsgröße x(t) und die Ausgangsgröße y(t) gilt dann die Beziehung:

$$Y(t) = \int_{t-20\,ms}^{t} x(t)\, dt$$

Es sei weiterhin angenommen, daß eine Periodendauer T in 256 Zeitabschnitte t unterteilt wird. Dann wird das Integral numerisch nach folgender rekursiven Differenzengleichung gebildet:

$$y(n) = y(n-1) + x(n) - x(n-256),$$

d.h., das aktuelle Integral errechnet sich aus dem eine Periode T früher gewonnenen Integral plus dem momentanen Abtastwert zur Zeit $T_n$ minus dem Abtastwert (n - 256), d.h. vor 20 ms. Dies hat zur Folge, daß nach einer Periodendauer T = 20 ms nach dem Anlegen der Netzspannung (bei 50 Hz) der genaue Gleichspannungsanteil bekannt ist und zur Kompensation zur Verfügung steht.

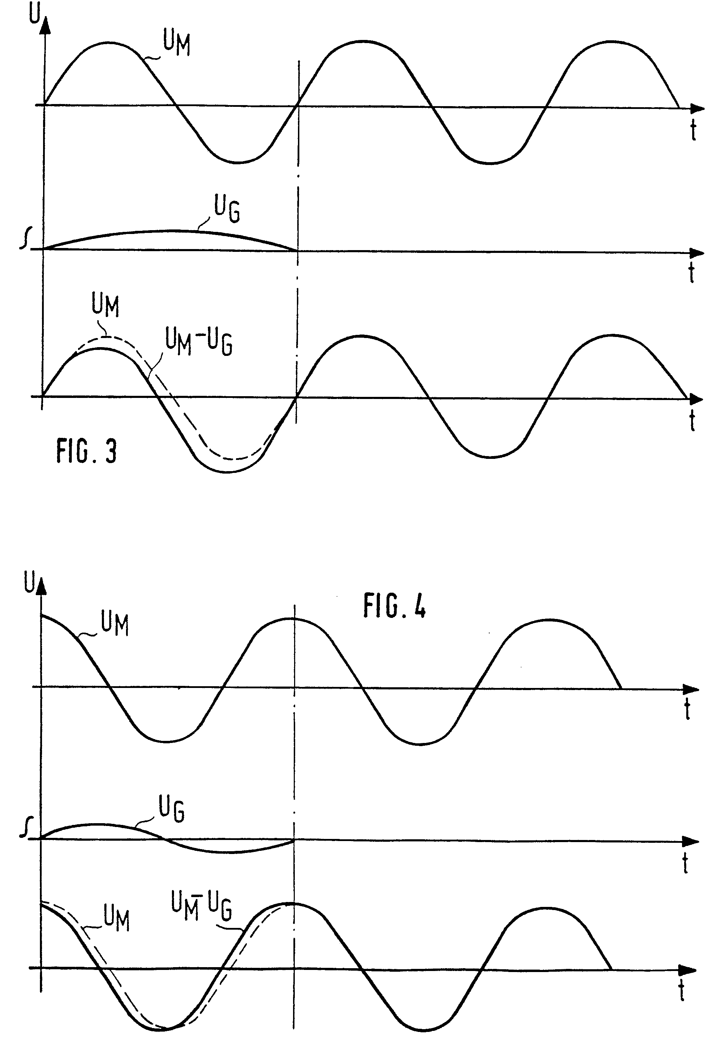

Bei dem in Fig. 3 dargestellten angenommenen Einschaltzeitpunkt im Nulldurchgang bei ansteigender Spannung erhält man ohne einen Gleichspannungsanteil in der Meßwechselspannung $U_M$ durch Integration dieser ersten Periode eine Integrationskurve, die in dieser ersten Periode einen Gleichspannungsanteil $U_G$ vortäuscht. Dieser tritt jedoch nur in der ersten Periode auf und bewirkt im ungünstigsten Fall eine geringfügige Versetzung der Meßwechselspannung $U_M$ um 1/3 der Eingangsamplitude. Mit Beginn der zweiten Periode ist diese Abweichung ausgeregelt.

Die Fig. 4 zeigt eine entsprechende Änderung der nicht mit einem Gleichspannungsanteil behafteten Meßwechselspannung $U_M$ beim Einschalten im Scheitelpunkt der positiven Halbwelle. Wie ersichtlich, wird die Meßwechselspannung hierbei wesentlich weniger verzerrt.

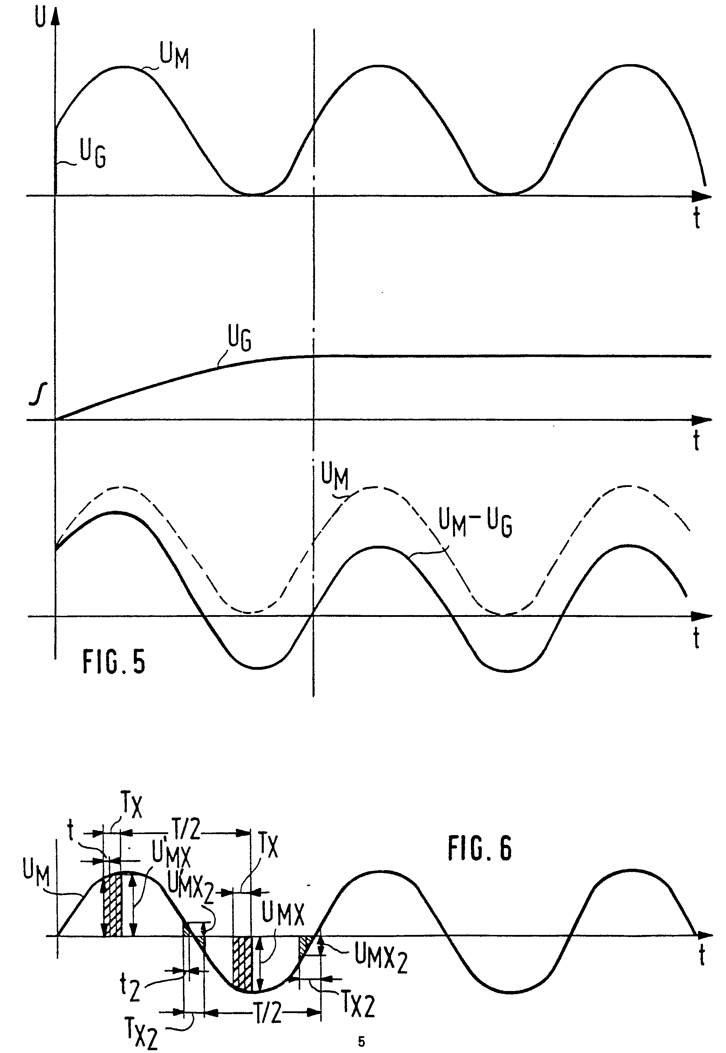

In Fig. 5 ist schließlich die Kompensation einer Gleichspannungskomponente $U_G$ der Meßwechselspannung $U_M$ bei Einschaltung im Nulldurchgang der Wechselspannungskomponente und bei einem positiven Gleichspannungsanteil in der Höhe des Spitzenwerts der Meßwechselspannung gezeigt. Es ist ersichtlich, daß nach einer Periode T der Gleichspannungsanteil voll kompensiert ist und zur Messung daher die reine Wechselspannung zur Verfügung steht, so daß im Meßwandler weder eine Sättigung des Wandlerkerns noch Verzerrungen durch eine einseitige Kern-Vormagnetisierung aufgrund eines Gleichspannungsanteiles auftritt.

Das erfindungsgemäße Verfahren, die zugehörige Schaltung und die Einrichtung zur Beseitigung der Gleichspannungskomponente sind für einen Einsatz bei allen Arten von Wechselspannungsnetzen geeignet, auch wenn das bevorzugte Einsatzgebiet Mittel- und Hochspannungsnetze sind.

Bei dem in Fig. 6 dargestellten Ausführungsbeispiel der Erfindung sind die Perioden oder Halbperioden ebenfalls in gleiche Zeitabschnitte t unterteilt. Hierbei wird jedoch innerhalb einer Halbperiode T/2 nur ein Teilabschnitt gemessen, der wenigstens drei aufeinanderfolgende Zeitabschnitte t umfaßt. Aus den einzelnen Momentanwerten $U_t$ der Meßwechselspannung $U_M$ wird der Spannungsmittelwert $U_{MX}$ gebildet, beispielsweise durch Addition der Momentanwerte $U_t$ und Division durch die Anzahl der herangezogenen Zeitabschnitte t. Durch die Verwendung mehrerer Zeitabschnitte t zur Mittelwertbildung gehen auftretende Spannungsspitzen oder Spannungszusammenbrücke nicht voll in das Meßergebnis ein, sondern diese werden ausgeglichen.

Der jeweilige Spannungsmittelwert $U_{MX}$ eines Teilabschnitts Tx wird jeweils mit dem eine Halbperiode T/2 früher ermittelten Spannungsmittelwert $U_{MX}'$ verglichen und die erhaltene Spannung invertiert dem Meßverstärker 14 eingegeben. Auf diese Weise wird bereits nach einer Halbperiode T/2 eine vollkommene Kompensation eines vorhandenen Gleichspannungsanteils in der Meßwechselspannung $U_M$ erreicht. Eine Kompensation erfolgt auch hier nach jedem Zeitabschnitt t.

In der Fig. 6 sind zwei Meßphasen dargestellt, wobei die erste grob von links unten nach rechts oben und die zweite fein von links oben nach rechts unten schraffiert ist und zur besseren Unterscheidung letztere mit dem Index 2 versehen ist.

Der Wirkungsablauf ist im wesentlichen derselbe wie beim ersten Ausführungsbeispiel, nur daß hier die Mittelwerte verglichen werden und zwar bereits nach einer Halbperiode T/2. Auch die Schaltung kann dabei die gleiche sein, nur daß anstelle der Integration eine Mittelwertbildung stattfindet. Beide Möglichkeiten können durch entsprechende Programmierung des Mikroprozessors 21 bzw. des zugeordneten oder beispielsweise mit dem Mikroprozessorchip integrierten Bausteines bewirkt werden.

Es ist noch zu erwähnen, daß erfindungsgemäß zum Einschaltzeitpunkt ein Vergleich mit der Referenzspannung Null über eine Periodendauer bei Anwendung der Integration bzw. über eine Halbperiode T/2 bei der Mittelwertbildung vorgenommen wird. Hierdurch wird von diesem Zeitpunkt an eine Gleichspannungskompensation erreicht, die ebenfalls bewirkt, daß der Meßwandler der Meßschaltung nicht in die Sättigung kommt.

**Patentansprüche**

1. Verfahren zur Beseitigung der Gleichspannungskomponente eines kapazitiven Wechselspannungsteilers, insbesondere für mittlere und hohe Spannungen, dessen Meßwechselspannung, die einen Gleichspannungsanteil aufweisen kann, einem Meßwandler zugeführt wird, dadurch gekennzeichnet, daß die Meßwechselspannung ($U_M$) über einen Kondensator (6) zwei parallelen Leitungen (L1, L2) eingegeben wird, wobei die Meßwechselspannung ($U_M$) über die eine Leitung (L1) direkt einem Meßverstärker (14) eingegeben wird und in der anderen Leitung (L2) der Gleichspannungsanteil ($U_G$) der Meßwechselspannung ($U_M$) ermittelt wird, indem die Meßwechselspannung ($U_M$) in so kleine Zeitabschnitte (t) unterteilt wird, daß je Periode (T) oder Halbperiode (T/2) eine gleiche Anzahl von Zeitabschnitten (t) zugeordnet ist und im Takt (Tf) der Zeitabschnitte (t) die Meßwechselspannung ($U_M$) fortlaufend jeweils über eine Periode (T) integriert wird und der so ermittelte jeweilige Gleichspannungsanteil ($U_G$) in Gegenphase zum ursprünglichen Wert dem Meßverstärker (14) und über diesen dem Meßwandler (16) eingegeben wird, wobei die Eingangsspannung ($U_M$ - $U_G$) des Meßwertverstärkers (14) aus der Summe der ihm eingegebenen Spannungen gebildet wird.

2. Verfahren zur Beseitigung der Gleichspannungskomponente eines kapazitiven Wechselspannungsteilers, insbesondere für mittlere und hohe Spannungen, dessen Meßwechselspannung, die einen Gleichspannungsanteil aufweisen kann, einem Meßwandler zugeführt wird, dadurch gekennzeichnet, daß die Meßwechselspannung ($U_M$) über einen Kondensator (6) zwei parallelen Leitungen (L1, L2) eingegeben wird, wobei die Meßwechselspannung ($U_M$) über die eine Leitung (L1) direkt einem Meßverstärker (14) eingegeben wird und in der anderen Leitung (L2) der Gleichspannungsanteil ($U_G$) der Meßwechselspannung ($U_M$) ermittelt wird, indem die Meßwechselspannung ($U_M$) in so kleine Zeitabschnitte (t) unterteilt wird, daß je Halbperiode (T/2) eine gleiche Anzahl von Zeitabschnitten (t) zugeordnet ist und im Takt (Tf) der Zeitabschnitte (t) fortlaufend jeweils aus den Momentanwerten ($U_t$) mehrerer aufeinanderfolgender, einen Teilabschnitt ($T_X$) einer Halbperiode (T/2) bildenden Zeitabschnitte (t) der Spannungsmittelwert ($U_{MX}$) gebildet und mit dem jeweiligen Spannungsmittelwert ($U'_{MX}$) der eine Halbperiode (T/2) früher liegenden gleichen Anzahl von Zeitabschnitten (t) verglichen wird, und daß daraus die Spannungsdifferenz dieser Spannungsmittelwerte ($U_{MX}$, $U'_{MX}$) ermittelt und diese invertiert dem Meßverstärker (14) eingegeben wird, wobei die Eingangsspannung ($U_M$ - $U_G$) des Meßverstärkers (14) aus der Summe der ihm eingegebenen Spannungen gebildet wird.

3. Verfahren nach Anspruch 2, dadurch gekennzeichnet, daß wenigstens drei Zeitabschnitte (t) zur Spannungsmittelwertbildung herangezogen werden.

4. Verfahren nach Anspruch 1, dadurch gekennzeichnet, daß die Unterteilung der Meßwechselspannung ($U_M$) in Zeitabschnitte (t) durch einen taktgesteuerten Analog-Digitalwandler (17) vorgenommen wird, daß die Digitalinformation einem vom gleichen Takt (Tf) gesteuerten digitalen Integrator (18) zugeführt wird, daß der digitale Integrator (18) in dieser Taktfolge (t) über eine Wechselspannungsperiode (T) den jeweiligen ermittelten Wert ($U_{GD}$) einer Periode (T) einem ebenfalls vom gleichen Takt (Tf) getakteten Digital-Analogwandler (19) eingibt, der aus dem digitalen Wert ($U_{GD}$) den Gleichspannungsanteil ($U_G$) erzeugt, der dem Meßverstärker (14) in Gegenphase zum tatsächlich in der Meßwechselspannung ($U_M$) vorhandenen Wert eingegeben wird.

5. Verfahren nach einem der Ansprüche 1 bis 4, dadurch gekennzeichnet, daß die Meßwechselspannung ($U_M$) in wenigstens einer der parallelen Leitungen (L1 und/oder L2) oder der Gleichspannungsanteil ($U_G$) derart verzögert wird, daß die Phasenlage der dem Meßverstärker (14) eingegebenen Spannung ($U_M$ - $U_G$) um genau eine oder mehrere Perioden (T) bzw. Halbperioden (T/2) gegenüber der Meßwechselspannung ($U_M$) verschoben ist.

6. Verfahren nach einem der Ansprüche 1 bis 5, dadurch gekennzeichnet, daß zur Steuerung der Verfahrensschritte, mittels denen der Gleichspannungsanteil ($U_G$) ermittelt wird, ein Mikroprozessor (21) verwendet wird.

7. Schaltung zum Anschalten an einen aus einem Ober- und einem Unterspannungskondensator gebildeten kapazitiven Wechselspannungsteiler zur Ausübung des Verfahrens gemäß einem der Ansprüche 1, 4, 5, wenn dieser auf Anspruch 1 oder 4 rückbezogen ist, und 6, wenn dieser auf Anspruch 1 oder 4 oder 5, bei Rückbeziehung des letzteren auf Anspruch 1 oder 4, rückbezogen ist, dadurch gekennzeichnet, daß an den Verbindungspunkt (5) zwischen dem Ober- und Unterspannungskondensator (2, 3) des kapazitiven Spannungsteilers (4) die eine Elektrode (7) eines Trennkondensators (6) angeschlossen ist, an dessen andere Elektrode (12) über eine Impedanz (13) ein Meßverstärker (14) angeschlossen ist und daß der Impedanz (13) ein Analog-Digitalwandler (17) in Reihe mit einem digitalen Integrator (18) und einem Digital-Analogwandler (19) parallelgeschaltet sind und letztere über einen gemeinsamen Taktgenerator (21) getaktet und angesteuert sind, wobei durch den Analog-Digitalwandler (17) die Meßwechselspannung ($U_M$) in gleiche Zeitabschnitte (t) unterteilbar und der jeweilige Spannungswert jedes Zeitabschnittes (t) in digitaler Form dem digitalen Integrator (18) eingebbar ist und letzterer aus den digitalen Spannungswerten über eine Periode (T) die Meßwechselspannung integrieren kann und diesen integrierten, dem jeweiligen Gleichspannungsanteil ($U_G$) der Meßwechselspannung ($U_M$) entsprechenden Wert fortlaufend im Takt der Zeitabschnitte (t) in digitaler Form dem Digital-Analogwandler (19) eingibt, der den dem jeweiligen Zeitabschnitt (t) entsprechenden Gleichspannungsanteil ($U_G$) in analoger Form in umgekehrter Phasenlage zum Gleichspannungsanteil der Meßwechselspannung ($U_M$), also invertiert, oder über einen Inverter dem Meßverstärker (14) eingibt.

8. Schaltung nach Anspruch 7, dadurch gekennzeichnet, daß die vom kapazitiven Spannungsteiler (4) abgenommene Meßwechselspannung ($U_M$) einem ohmschen Spannungsteiler (8) zugeführt und der Trennkondensator (6) an dessen Verbindungsknoten angeschlossen ist.

9. Schaltung nach Anspruch 7 oder 8, dadurch gekennzeichnet, daß zwischen dem kapazitiven bzw. ohmschen Spannungsteiler (4 bzw. 8) und dem Trennkondensator (6) ein Verstärker (11) eingeschaltet ist.

**Claims**

1. A method of elimination of the d.c. voltage component from a capacitive a.c. voltage divider, in particular for medium and high voltages, from which the measuring a.c. voltage which may exhibit a d.c. voltage component is fed to an instrument transformer characterized in that the measuring a.c. voltage ($U_M$) is fed via a capacitor (6) to two parallel leads (L1, L2), the measuring a.c. voltage ($U_M$) being fed via the one lead (L1) direct to a measured value amplifier (14) and the d.c. voltage component ($U_G$) of the measuring a.c. voltage ($U_M$) being determined in the other lead (L2) by the measuring a.c. voltage ($U_M$) being subdivided into such short intervals of time (t) that an equal number of intervals of time (t) is associated with each period (T) or half-period (T/2) and the measuring a.c. voltage ($U_M$) is integrated continuously over any one period (T) at the rhythm (Tf) of the intervals of time (t) and the d.c. voltage component ($U_G$) so determined at any time is fed in phase opposition to the original value to the measuring amplifier (14) and via the latter to the instrument transformer (16), the input voltage ($U_M$ - $U_G$) to the measured value amplifier (14) being formed from the sum of the voltages fed to it.

2. A method of elimination of the d.c. voltage component from a capacitive a.c. voltage divider, in particular for medium and high voltages, from which the measuring a.c. voltage which may exhibit a d.c. voltage component is fed to an instrument transformer, characterized in that the measuring a.c. voltage ($U_M$) is fed via a capacitor (6) to two parallel leads (L1, L2), the measuring a.c. voltage ($U_M$) being fed via the one lead (L1) direct to a measuring amplifier (14) and the d.c. voltage component ($U_G$) of the measuring a.c. voltage ($U_M$) being determined in the other lead (L2) by the measuring a. c. voltage ($U_M$) being subdivided into such short intervals of time (t) that an equal number of intervals of time (t) is associated with each half-period (T/2) and the mean value ($U_{MX}$) of the voltage is formed continuously at the rhythm (Tf) of the intervals of time (t) from the instantaneous values ($U_t$) at a number of successive intervals of time (t) forming one portion ($T_X$) of one half-period (T/2), and compared with the respective mean value ($U'_{MX}$) of the voltage from the same number of intervals of time (t) lying one half-period (T/2) earlier, and that from that the voltage difference between these mean values ($U_{MX}$, $U'_{MX}$) of the voltage is determined and fed inverted to the measuring amplifier (14), the input voltage ($U_M$ - $U_G$) to the measuring amplifier (14) being formed from the sum of the voltages fed to it.

3. A method as in Claim 2, characterized in that at least three intervals of time (t) are called upon for the formation of the mean value of the voltage.

4. A method as in Claim 1, characterized in that the subdivision of the measuring a.c. voltage ($U_M$) into intervals of time (t) is performed by a time-controlled analogue-digital converter (17), that the digital information is fed to a digital integrator (18) controlled at the same rhythm (Tf), that the digital integrator (18) at this time sequence (t) over one a.c. voltage period (T) feeds the respective value ($U_{GD}$) determined from one period (T) to a digital-analogue converter (19) which is likewise time-controlled at the same rhythm (Tf) and which generates from the digital value ($U_{GD}$) the d.c. voltage component ($U_G$) which is fed to the measuring amplifier (14) in phase opposition to the value actually existing in the measuring a.c. voltage ($U_M$).

5. A method as in one of the Claims 1 to 4, characterized in that the measuring a.c. voltage ($U_M$) in at least one of the parallel leads (L1 and/or L2) or the d.c. voltage component ($U_G$) is delayed in such a way that the phase position of the voltage ($U_M$ - $U_G$) fed to the measuring amplifier (14) is shifted by exactly one or more periods (T) or respectively half-periods (T/2) with respect to the measuring a.c. voltage ($U_M$).

6. A method as in one of the Claims 1 to 5, characterized in that for the control of the steps of the method by means of which the d.c. voltage component ($U_G$) is determined, a microprocessor (21) is employed.

7. A circuit for connection to a capacitive a.c. voltage divider formed from an upper voltage capacitor and a lower voltage capacitor, for implementation of the method in accordance with one of the Claims 1, 4 and 5 if the latter is referred back to Claim 1 or 4, and 6 if the latter is referred back to Claim 1 or 4 or 5 in the case of the latter being referred back to Claim 1 or 4, characterized in that to the point of connection (5) between the upper and lower voltage capacitors (2, 3) of the capacitive voltage divider (4) the one electrode (7) of a separator capacitor (6) is connected, to the other electrode (12) of which via an impedance (13) a measuring amplifier (14) is connected, and that in parallel with the impedance (13) an analogue-digital converter (17) is connected in series with a digital integrator (18) and a digital analogue converter (19) and the latter are time-controlled and energized via a common timing generator (21), so that through the analogue-digital converter (17) the measuring a.c. voltage ($U_M$) may be subdivided into equal intervals of time (t) and the respective value of the voltage from each interval of time (t) may be fed in digital form to the digital integrator (18) and the latter from the digital values of voltage can integrate the desired measuring a.c. voltage over a period (T) and feeds this integrated value corresponding with the d.c. voltage component ($U_G$) of the measuring a.c. voltage ($U_M$) at the time, continuously at the rhythm of the intervals of time (t) in digital form to the digital-analogue converter (19) which feeds the d.c. voltage component ($U_G$) corresponding with the respective interval of time (t) in analogue form in the phase position opposite to the d.c. voltage component of the measuring a.c. voltage ($U_M$), that is, inverted, or via an inverter to the measuring amplifier (14).

8. A circuit as in Claim 7, characterized in that the measuring a.c. voltage ($U_M$) taken off the capacitive voltage divider (4) is fed to an ohmic voltage divider (8) and the separating capacitor (6) is connected to the terminals of the latter.

9. A circuit as in Claim 7 or 8, characterized in that between the capacitive or ohmic voltage divider (4 resp. 8) and the separating capacitor (6) an amplifier (11) is interposed.

**Revendications**

1. Procédé pour éliminer la composante de tension continue d'un diviseur capacitif de tension alternative, notamment pour de moyennes et hautes tensions, dont la tension alternative de mesure, qui peut comporter une composante de tension continue, est appliquée à un convertisseur de mesure, procédé caractérisé en ce que la tension alternative de mesure ($U_M$) est appliquée par l'intermédiaire d'un condensateur (6) à deux liaisons parallèles (L1, L2), cette tension de mesure ($U_M$) étant appliquée directement à un amplificateur de mesure (14) par l'intermédiaire de l'une (L1) de ces liaisons, tandis que sur l'autre liaison (L2) la composante de tension continue ($U_G$) de la tension alternative de mesure ($U_M$) est déterminée en subdivisant la tension alternative de mesure ($U_M$) en périodes de temps suffisamment courtes (t) pour qu'à chaque période (T) ou à chaque demi-période (T/2) soit associé un même nombre de périodes de temps (t), et qu'à la cadence (Tf) des périodes de temps (t), la tension alternative de mesure ($U_M$) soit chaque fois intégrée de façon continue sur une période (T), et que la composante de tension continue ($U_G$) ainsi déterminée, soit appliquée, en opposition de phase par rapport à la valeur initiale, à l'amplificateur de mesure (14) et par l'intermédiaire de celui-ci au convertisseur de mesure (16), la tension d'entrée ($U_M - U_G$) de l'amplificateur de valeur de mesure (14) étant constituée par la somme des tensions qui lui sont appliquées.

2. Procédé pour éliminer la composante de tension continue d'un diviseur capacitif de tension alternative, notamment pour de moyennes et hautes tensions, dont la tension alternative de mesure, qui peut comporter une composante de tension continue, est appliquée à un convertisseur de mesure, procédé caractérisé en ce que la tension alternative de mesure ($U_M$) est appliquée par l'intermédiaire d'un condensateur (6) à deux liaisons parallèles (L1, L2), cette tension de mesure ($U_M$) étant appliquée directement à un amplificateur de mesure (14) par l'intermédiaire de l'une (L1) de ces liaisons, tandis que sur l'autre liaison (L2), la composante de tension continue ($U_G$) de la tension alternative de mesure ($U_M$) est déterminée en subdivisant la tension alternative de mesure ($U_M$) en périodes de temps suffisamment courtes (t), pour qu'à chaque demi-période (T/2) soit associé un même nombre de périodes de temps (t), et qu'à la cadence (Tf) des périodes de temps (t), la valeur moyenne de la tension ($U_{MX}$) soit chaque fois formée de façon continue à partir des valeurs momentanées ($U_t$) de plusieurs périodes de temps (t) successives, constituant une partie ($T_X$) d'une demi-période (T/2) et est comparée à la valeur moyenne de la tension respective ($U'_{MX}$) du même nombre de périodes de temps (t) de l'une des demi-périodes (T/2) précédentes, et à partir de là, la différence de ces valeurs moyennes de tension ($U_{MX}$, $U'_{MX}$) est déterminée et cette différence inversée est appliquée à l'amplificateur de mesure (14), la tension d'entrée ($U_M - U_G$) de l'amplificateur de mesure (14) étant constituée par la somme des tensions qui lui sont appliquées.

3. Procédé selon la revendication 2, caractérisé en ce qu'on fait appel à au moins trois périodes de temps (t) pour former la valeur moyenne de la tension.

4. Procédé selon la revendication 1, caractérisé en ce que la subdivision de la tension alternative de mesure ($U_M$) en périodes de temps (t) est effectuée par l'intermédiaire d'un convertisseur analogique-numérique commandé en synchronisme (17), l'information numérique étant appliquée à un intégrateur numérique (18) commandé selon le même synchronisme (Tf), cet intégrateur numérique (18) appliquant, selon cette succession d'impulsions (t) sur une période (T) de la tension alternative, la valeur respectivement déterminée ($U_{GD}$) d'une période (T) à un convertisseur numérique-analogique (19), également commandé selon ce même synchronisme, et qui détermine à partir de la valeur numérique ($U_{GD}$) la composante de tension continue ($U_G$), laquelle est appliquée, en inversion de phase par rapport à la valeur effectivement présente dans la tension alternative de mesure ($U_M$), à l'amplificateur de mesure (14).

5. Procédé selon une des revendications 1 à 4, caractérisé en ce que la tension alternative de mesure ($U_M$) dans au moins une des liaisons parallèles (L1 et/ou L2) ou bien la composante de tension continue ($U_G$) est retardée de façon que la position de phase de la tension ($U_M$ - $U_G$) appliquée à l'amplificateur de mesure (14) soit décalée précisément d'une ou plusieurs périodes (T) ou demi-périodes (T/2) par rapport à la tension alternative de mesure ($U_M$).

6. Procédé selon une des revendications 1 à 5, caractérisé en ce qu'on utilise un microprocesseur (21) pour commander les étapes du procédé au moyen desquelles est déterminée la composante de tension continue ($U_G$).

7. Circuit à raccorder à un diviseur capacitif de tension alternative constitué d'un condensateur haute tension et d'un condensateur basse tension, pour la mise en oeuvre du procédé selon une des revendications 1, 4, 5 si cette dernière se rattache à la revendication 1 ou 4 et 6 si cette dernière se rattache à la revendication 1 ou 4 ou 5, lorsque cette dernière se rattache à la revendication 1 ou 2, circuit caractérisé en ce qu'au point de jonction (5) entre le condensateur haute tension et le condensateur basse tension (2, 3) du diviseur de tension capacitif (4) est raccordée l'une (7) des électrodes d'un condensateur de séparation (6), dont l'autre électrode (12) est raccordée par l'intermédiaire d'une impédance (13) à un amplificateur de mesure (14), et sur l'impédance (13) est branché en parallèle, le montage en série d'un convertisseur analogique-numérique (17) avec un intégrateur numérique (18) et un convertisseur numérique-analogique (19), ces derniers étant commandés et synchronisés par un générateur d'impulsions commun (21), cependant que la tension alternative de mesure ($U_M$) est susceptible d'être subdivisée par le convertisseur analogique-numérique (17) en périodes de temps (t) égales, et la valeur de tension respective de chaque période de temps (t) sous forme numérique, est susceptible d'être appliquée à l'intégrateur numérique (18), et ce dernier peut intégrer la tension alternative de mesure sur une période (T) à partir des valeurs numériques de tension, et applique cette valeur intégrée, correspondant à la composante de tension continue respective ($U_G$) de la tension alternative de mesure ($U_M$), de façon continue à la cadence des périodes de temps (t), sous forme numérique, au convertisseur numérique-analogique (19), qui applique à l'amplificateur de mesure la composante de tension continue ($U_G$) correspondant à la période respective de temps (t), mise sous forme analogique et en opposition de phase avec la composante de tension continue de la tension alternative de mesure ($U_M$), donc inversée, ou bien qui l'applique à l'amplificateur de mesure (14) par l'intermédiaire d'un inverseur.

8. Circuit selon la revendication 7, caractérisé en ce que la tension alternative de mesure ($U_M$) reçue du diviseur capacitif de tension (4) est appliquée à un diviseur ohmique de tension (8) et le condensateur de séparation (6) est raccordé à leur point de jonction.

9. Circuit selon la revendication 7 ou 8, caractérisé en ce qu'un amplificateur (11) est branché entre le diviseur de tension capacitif ou bien ohmique (4 ou 8) et le condensateur de séparation (6).

**FIG.1**

**FIG. 2**

FIG. 3

FIG. 4

FIG. 5

FIG. 6

5